Europäisches Patentamt

European Patent Office

Office européen des brevets

(11) Veröffentlichungsnummer: **0 180 793**
**B1**

## EUROPÄISCHE PATENTSCHRIFT

(45) Veröffentlichungstag der Patentschrift:
**31.01.90**

(51) Int. Cl.⁴: **G 06 F 5/00**

(21) Anmeldenummer: **85112736.5**

(22) Anmeldetag: **08.10.85**

(54) **Anordnung zur Umsetzung von Codewörtern mit unterschiedlicher Länge in Datenwörter gleicher Länge.**

(30) Priorität: **12.10.84 DE 3437503**

(43) Veröffentlichungstag der Anmeldung:
**14.05.86 Patentblatt 86/20**

(45) Bekanntmachung des Hinweises auf die Patenterteilung:
**31.01.90 Patentblatt 90/5**

(84) Benannte Vertragsstaaten:
**AT BE CH DE FR GB IT LI NL SE**

(56) Entgegenhaltungen:
**US-A- 4 236 206**

**NUCLEAR INSTRUMENTS AND METHODS, Band 131, Nr. 3, 28. Dezember 1975, Seiten 541-547, North-Holland Publishing Co., Amsterdam, NL; D.J. FEGAN: "A fast inexpensive 1024-Bit buffer memory data acquisition system for cosmic ray data using TTL integrated circuits and a paper tape punch"**
**IBM TECHNICAL DISCLOSURE BULLETIN, Band 23, Nr. 2, Juli 1980, Seiten 791-795, New York, US; G.G. LANGDON: "High speed conversion between variable and fixed length words"**
**IBM TECHNICAL DISCLOSURE BULLETIN, Band 15, Nr. 8, Januar 1973, Seiten 2495-2496, New York, US; L.B. BAUMER: "Read-only memory controlled buffering"**
**ELECTRONICS, Band 52, Nr. 2, Januar 1979, Seite 147; T.V. NHUYEN: "Selectors squeeze data into random-access memories"**

(73) Patentinhaber: **Siemens Aktiengesellschaft, Wittelsbacherplatz 2, D-8000 München 2 (DE)**

(72) Erfinder: **Grallert, Hans-Joachim, Dr.-Ing., Tannenfleckstrasse 30, D-8038 Gröbenzell (DE)**
Erfinder: **Liegl, Werner, Dipl.-Ing., Blumenstrasse 4, D-8061 Schwabhausen (DE)**

## Beschreibung

Die Erfindung betrifft eine Anordnung nach dem Oberbegriff des Patentanspruchs 1.

Bei der Übertragung von DPCM-codierten Farbbildkomponenten wird häufig eine Codierung mit variabler Wortlänge verwendet, die einen unregelmässigen Datenfluss erzeugt. Zur Durchführung einer Fehlersicherung, einer einfachen Weiterverarbeitung und zur Übertragung ist es erforderlich, dass ein kontinuierlicher Fluss von Datenwörtern konstanter Länge erzeugt wird.

Aus IBM Technical Disclosure Bulletin, Band 23, Nr. 2, Juli 1980, Seiten 791–795, New York, US; G.G. Langdon: «High speed conversion between variable and fixed length words» ist eine Einrichtung zur Umsetzung von Datenwörtern unterschiedlicher Länge in Datenwörter fester Länge bekannt. Diese Einrichtung besteht im wesentlichen aus zwei Registern, einem Multiplexer und einer Steuerung. Das erste Register ist speziell ausgebildet und dient zur Aneinanderreihung der aufeinanderfolgenden Datenwörter unterschiedlicher Länge. Ergibt sich hierdurch ein zusammengesetztes Datenwort mit der vorgegebenen konstanten Wortlänge oder wird diese Wortlänge überschritten, so wird das zusammengesetzte Datenwort bzw. dessen höherwertigen Bits ausgesendet. Die nicht ausgesendeten Bits werden über den Multiplexer im zweiten Register zwischengespeichert und mit dem nächsten Datenwort unterschiedlicher Länge zusammengefügt. Diese Einrichtung ist universell verwendbar, sie benötigt jedoch einen erheblichen Aufwand für die Steuerung und das erste Register.

Es ist die Aufgabe der Erfindung, eine für hohe Datenraten geeignete Anordnung zur Umsetzung von Codewörtern unterschiedlicher Länge in gleichlange Datenwörter anzugeben.

Ausgehend vom einleitend angegebenen beschriebenen Stand der Technik wird diese Aufgabe durch die im Patentanspruch 1 angegebenen Merkmale gelöst.

Bei dieser Schaltung ist es vorteilhaft, dass die maximale Verarbeitungsgeschwindigkeit, also die Arbeitstaktfrequenz, der Codewortfrequenz entspricht. Hat das Speicherregister soviel Speicherplätze, wie sie dem kleinsten gemeinsamen Vielfachen der unterschiedlichen Wortlängen der Codewörter und des Datenwortes entspricht, vereinfacht sich der Schaltungsaufwand für die Multiplexer und für die Steuerung der Einschreib- und Auslesevorgänge erheblich. Durch die Umsetzung der Codewörter in Datenwörter, die das mehrfache der benötigten endgültigen Wortlänge aufweisen, wird die Verarbeitungsgeschwindigkeit nochmals herabgesetzt. Dies ist besonders bei der Codierung von Fernsehsignalen von Bedeutung.

Ein Ausführungsbeispiel der Erfindung wird anhand der Fig. 1 bis 3 näher erläutert.

Fig. 1 ein Prinzipschaltbild der erfindungsgemässen Anordnung,

Fig. 2 ein Ausführungsbeispiel hierzu und
Fig. 3 ein Prinzipschaltbild der Steuerung.

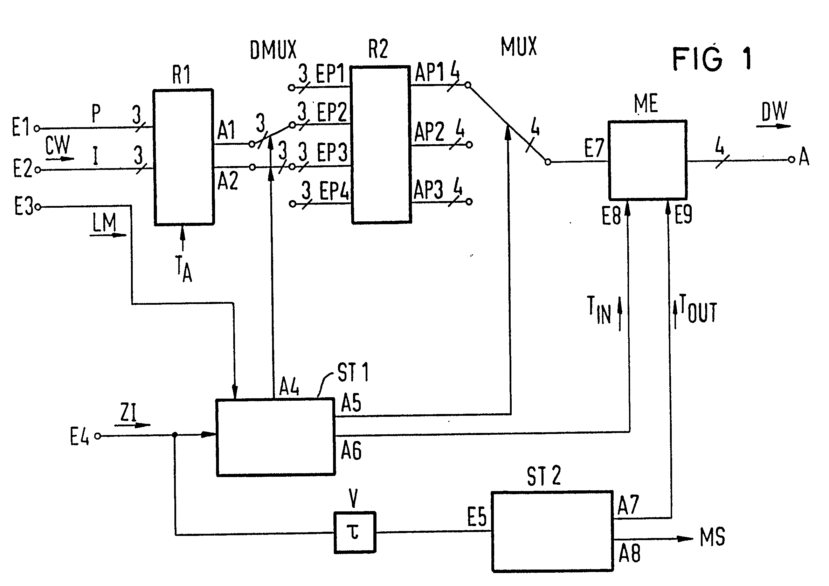

Das in Fig. 1 dargestellte Prinzipschaltbild enthält die Reihenschaltung eines ersten Registers R1, eines Demultiplexers DMUX, eines Speicherregisters R2, einer Datenwort-Multiplexeinrichtung MUX und eines FIRST-IN/FIRST-OUT-Speichers (FIFO) ME. An den zwei Eingängen E1 und E2 des ersten Registers liegen die Präambel P der Codewörter und ihr Informationsteil I an. Die entsprechenden Ausgänge sind mit A1, A2 bezeichnet. In diesem Ausführungsbeispiel wird angenommen, dass Codewörter CW mit zwei unterschiedlichen Längen vorhanden sind. Die kürzeren Codewörter weisen nur den Informationsteil I von drei Bits Länge auf, während die längeren Codewörter zusätzlich die Präambel P mit ebenfalls drei Bits aufweisen. Die Bitkombination der Präambel ist im Informationsteil nicht vorhanden. Der Demultiplexer DMUX weist zwei Eingänge mit jeweils drei Bits auf und ebenfalls zwei entsprechende Ausgänge, die beliebig an die Paralleleingänge EP – hier vier Eingänge EP1 bis EP4 mit jeweils drei Bits Breite – des Speicherregisters R2 anschaltbar sind. Ausserdem weist das Speicherregister R2 Parallelausgänge AP – hier drei Ausgänge AP1 bis AP3 mit jeweils vier Bits Breite auf, von denen jeweils ein Ausgang über einen Multiplexer MUX an den Dateneingang E7 des FIFO-Speichers ME angeschaltet ist. Am Ausgang A des FIFO-Speichers werden Datenwörter DW mit vier Bits Länge abgegeben. Zur Steuerung des Demultiplexers DMUX, der Datenwort-Multiplexeinrichtung MUX und des FIFO-Speichers ME sind zwei Steuerungen ST1 und ST2 vorhanden. Der ersten Steuerung ST1 wird über einen Eingang E3 ein Längemodus LM zugeführt, der die Länge der anliegenden Codewörter CW angibt. Drei Steuerausgänge A4, A5 und A6 greifen in den Demultiplexer DMUX, die Multiplexeinrichtung MUX und in den FIFO-Speicher ME über dessen Schreibtakt-Eingang E8 ein.

Beide Steuerungen werden mit einem an einem Eingang E4 liegenden Zeilenimpuls ZI gestartet. Die erste Steuerung ST1 steuert in Abhängigkeit von dem Längenmodus LM über ihren Ausgang A4 den Demultiplexer DMUX, über ihren Ausgang A5 die Datenwort-Multiplexeinrichtung MUX und über den Ausgang A6 den Einschreibtakt $T_{IN}$ des FIFO-Speichers. Der Zeilenimpuls ZI gelangt über eine Verzögerungsschaltung V zum Eingang E5 der zweiten Steuerung ST2, die über ihren Ausgang A7 einen konstanten Auslesetakt $T_{OUT}$ an den Lesetakt-Eingang E9 des FIFO-Speichers liefert und an ihrem Ausgang A8 weitere Takte und Impulse MS zur Multiplexbildung mit anderen Signalkomponenten bei der Übertragung von Farbsignalen sowie die notwendigen Bildimpulse abgibt. Ein an den Ausgängen A1, A2 des ersten Registers R1 anliegendes Codewort mit 6 Bits Länge wird, wie in Fig. 1 dargestellt, beispielsweise über den zweiten und dritten Eingang EP2, EP3 in das Speicherregister R2 eingeschrieben. Das nächste am Ausgang A2 des ersten Registers R1 anliegende Codewort soll nur drei Bits aufweisen; dies wird über den vierten Eingang EP4 in das Speicherregister R2 eingeschrieben. Anschliessend wird das nächste Codewort über den ersten Eingang EP1 des Speicherregisters eingeschrieben usw. Die Zahlen an den Verbindungen zwischen Bausteinen geben jeweils die Breite des Verbindungsbusses an.

Die erste Steuerung ST1 enthält eine Zählvorrichtung, die angibt, ob mindestens vier Bits im Speicherregister R2 eingeschrieben wurden. Ist dies der Fall, so wird ein Datenwort mit vier Bits Länge über die Datenwort-Multiplexeinrichtung MUX aus dem Speicherregister R2 ausgelesen und in den FIFO-Speicher ME eingeschrieben. Anschliessend werden die nächsten vier Bits aus dem Speicherregister R2 als neues Datenwort ausgelesen. Das Speicherregister R2 muss als Mindestlänge das kleinste gemeinsame Vielfache der unterschiedlichen Codewortlängen und der Wortlänge der ausgelesenen Datenwörter, in diesem Fall somit 12 Bits, aufweisen.

Nach jedem Zeilenimpuls wird zunächst eine bestimmte Anzahl von Datenwörtern DW in den FIFO-Speicher ME eingeschrieben, bevor das erste Datenwort dieser Zeile ausgelesen wird. Hierdurch ist stets für einen kontinuierlichen Datenfluss am Ausgang A des FIFO-Speichers ME, auch bei häufig auftretenden Codewörtern kleiner Länge, gesorgt. Über die erste Steuerung wird zudem sichergestellt, dass innerhalb jeder Fernsehzeile eine konstante Anzahl von Datenwörtern durch Einlesen von Leerkombinationen in den FIFO-Speicher eingeschrieben wird. Durch die dieser beschriebenen Anordnung vorgeschaltete Codiereinrichtung ist bereits sichergestellt, dass Codewörter mit grosser Länge nicht zu häufig vorkommen und ein Überlaufen des FIFO-Speichers ME verursachen können.

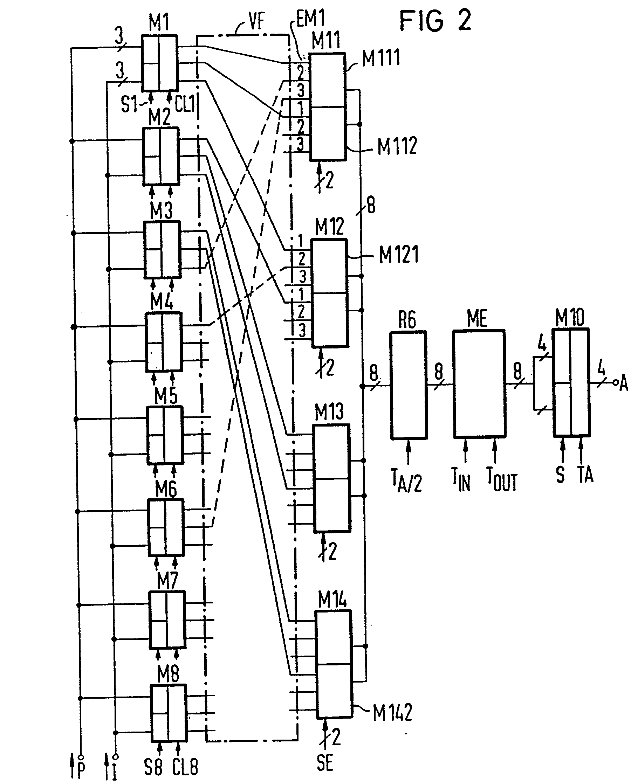

In Fig. 2 ist eine realisierte Schaltungsanordnung des Demultiplexers DMUX, des Speicherregisters R2 und der Datenwort-Multiplexeinrichtung MUX dargestellt. Der Demultiplexer DMUX wird durch acht Multiplexer M1 bis M8 realisiert, die jeweils entsprechend der Wortlänge a = 3 der Präambel P und des Informationsteils I zweimal drei Eingänge und drei Ausgänge aufweisen. Die Multiplexer M1 bis M8 (74 LS 399 der Fa. Texas Instruments) enthalten Speicherstufen, die das Speicherregister R2 bilden. Nicht benötigte Eingänge der Bausteine werden an Masse gelegt, die nicht benötigten Ausgänge bleiben frei. Bei dieser Realisierung weist das Speicherregister 24 Speicherplätze auf. Dies hat den Vorteil, dass acht Bits lange Datenwörter ausgelesen und in den FIFO-Speicher ME eingeschrieben werden. Die Datenwortmultiplexeinrichtung MUX enthält vier Multiplexerbausteine M11 bis M14 (74 LS 153 der Fa. Texas Instruments) mit jeweils zwei Datenwort-Multiplexern M111, M112 ... M142 mit vier (drei benötigten) Eingängen und einem Ausgang. Alle Ausgänge der Multiplexerbausteine M11 bis M14 bilden einen acht Bits breiten Datenbus, der über ein sechstes Register R6 mit dem Dateneingang E7 des FIFO-Speichers ME (TDC 1030 der Fa. TRW, LSI Products Division, La Jolla, Ca. 92038) verbunden ist, dessen Ausgang an die Eingänge eines weiteren Multiplexers M10 mit zweimal vier Eingängen und vier Ausgangsleitungen angeschlossen ist.

In jeden der Multiplexer M1 bis M8 werden jeweils drei Bits eines Codewortes (Präambel P oder Informationsteil I) eingelesen. Die Steuerung des Einschreibvorganges erfolgt über die zugehörigen Selekt-Eingänge S1 bis S8 und die Takteingänge CL1 bis CL8. Die acht ersten Ausgänge der das Speicherregister bildenden drei ersten Multiplexer M1 bis M3 sind jeweils mit dem ersten Eingang EM1 der acht Datenwort-Multiplexer (M111 bis M142) der vier Multiplexerbausteine M11 bis M14 verbunden. Das erste acht Bits lange Datenwort wird aus den Registern der Multiplexer M1 bis M3 ausgelesen, indem über die zusammengeschalteten Selekt-Eingänge SE der Datenwort-Multiplexer M111 bis M142 jeweils der erste Eingang EM1 der Datenwort-Multiplexer auf den Ausgang durchgeschaltet wird. In derselben Weise werden die folgenden in den Registern der Multiplexer M3 bis M8 gespeicherten zwei weiteren Datenwörter ausgelesen, indem jeweils alle zweiten bzw. dritten Eingänge EM2 bzw. EM3 der Datenwort-Multiplexer der Multiplexerbausteine M11 bis M14 an die Ausgänge durchgeschaltet werden. Nach einer Zwischenspeicherung im sechsten Register R6 erfolgt das Einschreiben der Datenwörter in den FIFO-Speicher ME. Aus diesem werden wiederum acht Bits lange Datenwörter ausgelesen, die durch den weiteren Multiplexer M10 – gesteuert über dessen Selekteingang S – in vier Bits lange Datenwörter umgesetzt werden.

Die Verwendung von acht Bits langen Datenwörtern hat den Vorteil, dass die Verarbeitungsgeschwindigkeit entsprechend herabgesetzt wird. Entsprechend weisen die dem sechsten Register und dem FIFO-Speicher zugeführten Arbeitstakte $T_{A/2}$, $T_{IN}$ und $T_{OUT}$ die halbe Frequenz des Arbeitstaktes $T_A$ auf, mit dem vier Bits lange Datenwörter ausgesendet werden.

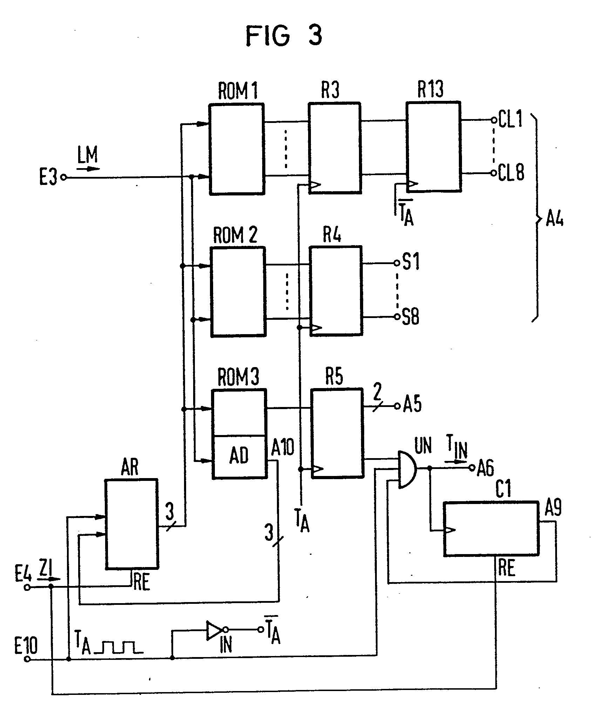

Die Ausführung der ersten und zweiten Steuerung ST1, ST2 bereitet für den Fachmann keinerlei Schwierigkeiten. Es muss jedoch stets die bei der Codierung von Fernsehsignalen oder anderen Bildsignalen erforderliche Arbeitsgeschwindigkeit berücksichtigt werden. Die erste Steuerung ST1 kann nach Fig. 3 als Lesespeichersteuerung ausgeführt werden. Es sind drei Lesespeicher (EPROM, PROM, ROM) ROM1 bis ROM3 (Baustein 74 S 288 Fa. Texas Instr.) vorgesehen, deren Adresseneingänge mit dem Ausgang eines Adressenregisters AR und mit dem Eingang E3 für den Längemodus LM verbunden sind. Die Codewörter werden im ersten Register R1 zwischengespeichert, so dass sie gegenüber dem Längenmodus LM verzögert sind. Die Ausgänge des ersten Lesespeichers ROM1 sind über ein drittes Register R3 und ein nachgeschaltetes Register R13 auf die Takteingänge CL1 bis CL8 der Multiplexer M1 bis M8 geführt. Dem dritten Register R3 wird der am Eingang E10 anliegende Arbeitstakt $T_A$ und dem nachgeschalteten Register R13 der invertierte Arbeitstakt $\overline{T}_A$ zugeführt. Die Ausgänge des zweiten Lesespeichers ROM2 sind über ein viertes Register R4 an die Selekt-Eingänge S1 bis S8 der Multiplexer M1 bis M8 geführt. Ein Ausgang des dritten Lesespeichers ROM3 ist über ein fünftes Register R5 mit den zusammengeschalteten Selekt-Eingängen SE der Multiplexerschaltungen M11 bis M14 verbunden. Ausserdem enthält der dritte Lesespeicher ROM3 eine Additionseinrichtung AD. Die zugehörigen Datenausgänge A10 sind mit dem Eingang des Adressenregisters AR verbunden, dem ebenfalls der Arbeitstakt $T_A$ zugeführt ist. Der invertierte Arbeitstakt $\overline{T}_A$ wird durch einen Inverter IN erzeugt. Der Ausgang A9 eines Binärzählers C1 ist mit dem Eingang eines UND-Gatters UN verbunden. Ein weiterer Eingang des UND-Gatters UN ist an das fünfte Register R5 angeschlossen; ausserdem wird dem UND-Gatter der Arbeitstakt $T_A$ zugeführt. Der Ausgang des UND-Gatters UN liefert den Einschreibtakt $T_{IN}$ für den FIFO-Speicher ME und ist ausserdem mit dem Takteingang des Binärzählers C1 verbunden. Die Rücksetzeingänge RE des Binärzählers C1 und des Adressenregisters AR sind mit dem Eingang E4 verbunden.

Zu Beginn einer neuen Fernsehzeile werden das Adressenregister AR und der Binärzähler C1 in eine definierte Anfangslage gesetzt. Über den zweiten Lesespeicher ROM2 und das vierte Register R4 werden zunächst in Abhängigkeit von dem Längenmodus LM die Selekt-Eingänge des ersten Multiplexers M1 und des zweiten Multiplexers M2 angesteuert. Ein drei Bits umfassendes Codewort wird in den ersten Multiplexer M1 eingespeichert; ein sechs Bits umfassendes Codeword wird in den ersten Multiplexer M1 und den zweiten Multiplexer M2 gesteuert durch die über das dritte Register R3 und das nachgeschaltete Register R13 erzeugten Taktimpulse CL1 bzw. CL1 und CL2 eingespeichert.

Durch die am dritten Lesespeicher ROM3 anliegende Adresse wird an dessen Datenausgang A10 eine von der Länge des eingelesenen Codewortes, also dem Längenmodus LM, abhängige neue Adresse ausgegeben und in das Adressenregister AR eingeschrieben. Durch diese wird über die Lesespeicher ROM1 und ROM2 der nächste Multiplexer, beispielsweise M3 ausgewählt, in den ein drei Bits langes Codewort eingeschrieben wird. Da jetzt neun Bits in die Register der Multiplexer M1 bis M3 eingelesen wurden, kann anschliessend vom dritten Lesespeicher ROM3 über das fünfte Register R5 am Ausgang A5 ein Selektionssignal an die Datenwortmultiplexer abgegeben werden, das jeweils den ersten Eingang der Multiplexer der Multiplexerbausteine M11 bis M14 durchschaltet und die ersten acht Bits aus dem Speicherregister in das sechste Register R6 übernimmt. Die folgenden Codewörter werden in die nächsten Multiplexer M4 bis M8 eingeschrieben und jeweils – sobald wie möglich – durch Ansteuerung der Selekt-Eingänge SE der Multiplexerbausteine M11 bis M14 ausgelesen und in den FIFO-Speicher ME eingeschrieben. Anschliessend beginnt das Einschreiben mit dem ersten Multiplexer M1 von neuem.

Während bei richtiger Bemessung des FIFO-Speichers ME ein Überlaufen durch Begrenzen der Anzahl von 6-Bit-Codewörtern durch den vorgeschalteten Codierer verhindert ist, wird durch den Binärzähler C1 dafür gesorgt, dass in jeder Fernsehzeile dieselbe Anzahl von 4-Bit-Datenwörtern durch Ergänzung mit Leerkombinationen in den FIFO-Speicher eingeschrieben wird. Ist diese vorgegebene Anzahl erreicht, so werden über den Ausgang A9 des Binärzählers C1 und über das UND-Gatter UN die Einschreibimpulse $T_{IN}$ gesperrt. Da empfangsseitig die ursprünglichen Codewörter rekonstruiert werden, die für jede Fernsehzeile eine konstante Anzahl aufweisen, können beliebige Leerkombinationen zum Auffüllen des FIFO-Speichers ME verwendet werden.

Wie bereits erwähnt, beginnt das Auslesen der Fernsehzeile verzögert. Entsprechend müssen auch die Bildimpulse verzögert ausgesendet werden und ebenfalls der Auslesevorgang aus dem FIFO-Speicher nach Beginn des ersten Einlesevorganges, beispielsweise nach jedem Bildwechsel, verzögert beginnen. Dies wird durch das Verzögerungsglied V erreicht, das der zweiten Steuerung ST2 vorgeschaltet ist. Nach Beginn des Auslesevorgangs aus dem FIFO-Speicher wird der Auslesetakt $T_{OUT}$ ständig von der Steuerung ST2 abgegeben. Das Auffüllen der Fernsehzeilen mit Leerkombinationen ist notwendig, da sich Ein- und Auslesevorgänge bei aufeinanderfolgenden Fernsehzeilen überschneiden.

Da die zweite Steuerung ST2 im wesentlichen für die vorliegende Erfindung unwesentliche Einrichtungen zur Bildung der Multiplexsignale MS und zur Verzögerung der Bildimpulse enthält, braucht auf sie nicht weiter eingegangen zu werden.

## Patentansprüche

1. Anordnung zur Umsetzung von Codewörtern (CW) unterschiedlicher Länge in Datenwörter (DW) gleicher Länge, dadurch gekennzeichnet, dass ein Demultiplexer (DMUX) vorgesehen ist, dem die Codewörter (CW) in paralleler Form zugeführt werden, dass die Ausgänge des Demultiplexers (DMUX) mit Paralleleingängen (EP) eines Speicherregisters (R2) verbunden sind, dass die Parallelausgänge (AP) des Speicherregisters (R2) über eine Datenwort-Multiplexeinrichtung (MUX) an Dateneingänge (E7) eines Speichers (ME) angeschlossen sind und dass Steuereinrichtungen (ST1, ST2) für den Demultiplexer (DMUX), die Datenwort-Multiplexeinrichtung (MUX) und für den Speicher (ME) vorgesehen sind.

2. Anordnung nach Anspruch 1, dadurch gekennzeichnet, dass als Speicher (ME) ein FIRST IN/FIRST OUT-Speicher vorgesehen ist.

3. Anordnung nach Anspruch 1, dadurch gekennzeichnet, dass die Codewörter (CW) ein ganzzahliges Vielfaches (1, 2, 3...) der Anzahl «a» (3) der Bits des kürzesten Codewortes aufweisen und dass die Anzahl der Speicherstufen des Speicherregisters (R2) der Anzahl «a» der Bits des kürzesten Codewortes (CW) multipliziert mit der Anzahl der Bits eines Datenwortes (DW) oder einem ganzzahligen Vielfachen hiervon entspricht.

4. Anordnung nach Anspruch 3, dadurch gekennzeichnet, dass die Codewörter (CW) zwei unterschiedliche Längen aufweisen, dass das kurze Codewort nur einen Informationsteil (I) der Länge von «a» (3) Bits aufweist und dass das längere Codewort (CW) ebenfalls einen Informationsteil (I) und zusätzlich eine Präambel (P) der Länge von «a» Bits aufweist.

5. Anordnung nach Anspruch 4, dadurch gekennzeichnet, dass als Demultiplexer (DMUX) mehrere Multiplexer (M1 bis M8) vorgesehen sind, von denen jeweils ein Dateneingang eines Multiplexers (M1) mit den entsprechenden Dateneingängen der übrigen Multiplexer (M2 bis M8) parallelgeschaltet ist, dass den Dateneingängen jedes Multiplexers (M1 bis M8) die möglicherweise vorhandene Präambel (P) und seinen alternativ durchschaltbaren Dateneingängen der Informationsteil (I) des Codewortes (CW) zugeführt ist und dass die Selekt-Eingänge (S1 bis S8) der Multiplexer (M1 bis M8) separat ansteuerbar sind.

6. Anordnung nach Anspruch 5, dadurch gekennzeichnet, dass die Multiplexer (M1 bis M8) taktgesteuerte Speicherstufen enthalten, die das Speicherregister (R2) bilden.

7. Anordnung nach Anspruch 5, dadurch gekennzeichnet, dass die Datenwort-Multiplexeinrichtung (MUX) Datenwort-Multiplexer (M111 bis M142) mit jeweils «a» (3) Eingängen enthält, von denen jeweils gleichrangige Eingänge (EM1) mit aufeinanderfolgenden Ausgängen des Speicherregisters (R2) verbunden sind, und dass alle gleichrangigen Selekt-Eingänge (SE) der Datenwort-Multiplexer parallelgeschaltet sind.

8. Anordnung nach Anspruch 4, dadurch gekennzeichnet, dass Codewörter (CW) mit 3 oder 6 Bits Länge verwendet werden, dass ein Datenwort (DW) 4 Bits umfasst und dass das Speicherregister (R2) 24 Speicherstufen umfasst, dass 8 Datenwort-Multiplexer (M111 bis M142) zum gleichzeitigen Auslesen von jeweils 2 Datenwörtern (DW) vorgesehen sind.

9. Anordnung nach Anspruch 3, dadurch gekennzeichnet, dass die erste Steuerung (ST1) ein Adressenregister (AR) enthält, dass die Ausgänge des Adressenregisters (AR) mit Adresseneingängen von Lesespeichern (ROM1 bis ROM3) verbunden sind, dass die Ausgänge der Lesespeicher (ROM1 bis ROM3) über Register (R4, R5, R3, R13) mit den Selekt-Eingängen (S, SE) der Multiplexer (M1 bis M8) und der Datenwort-Multiplexer (M111 bis M142) und mit den Takteingängen (CL) des Speicherregisters (R2) verbunden sind, dass ein weiterer Ausgang eines Lesespeichers (ROM3) an den Eingang eines UND-Gatters (UN) zur Steuerung des Schreibimpulses (T$_{IN}$)

des Speichers (ME) geführt ist und dass die Ausgänge des Adressenregisters (AR) über eine Additionseinrichtung (AD), der auch der Längenmodus (LM) zugeführt ist, auf die Adresseneingänge des Adressenregisters (AR) zurückgekoppelt sind.

10. Anordnung nach Anspruch 9, dadurch gekennzeichnet, dass die Additionseinrichtung (AD) in einem Lesespeicher (ROM3) beinhaltet ist, der als neues Datenwort eine Adresse ausgibt, die entsprechend der anliegenden Adresse und des anliegenden Längenmodus (LM) gebildet ist.

## Claims

1. Arrangement for the conversion of codewords (CW) of varying length into datawords (DW) of constant length, characterized in that a demultiplexer (DMUX) is provided, to which the codewords (CW) are fed in parallel form, in that the outputs of the demultiplexer (DMUX) are connected to parallel inputs (EP) of a memory register (R2), in that the parallel outputs (AP) of the memory register (R2) are connected via a dataword-multiplexing device (MUX) to data inputs (E7) of a memory (ME) and in that control devices (ST1, ST2) are provided for the demultiplexer (DMUX), the dataword-multiplexing device (MUX) and for the memory (ME).

2. Arrangement according to Claim 1, characterized in that a FIRST IN/FIRST OUT memory is provided as the memory (ME).

3. Arrangement according to Claim 1, characterized in that the codewords (CW) have an integral multiple (1, 2, 3...) of the number "a" (3) of bits of the shortest codeword and in that the number of memory stages of the memory register (R2) corresponds to the number "a" of bits of the shortest codeword (CW) multiplied by the number of bits of a dataword (DW) or by an integral multiple thereof.

4. Arrangement according to Claim 3, characterized in that the codewords (CW) are of two varying lengths, in that the short codeword has only one information part (I) of the length of "a" (3) bits and in that the longer codeword (CW) also has an information part (I) and in addition a preamble (P) of the length of "a" bits.

5. Arrangement according to Claim 4, characterized in that as the demultiplexer (DMUX) a plurality of multiplexers (M1 to M8) is provided, of which in each case a data input of one multiplexer (M1) is connected in parallel to the corresponding data inputs of the other multiplexers (M2 to M8), in that the preamble (P), which may be present, is fed to the data inputs of each multiplexer (M1 to M8) and the information part (I) of the codeword (CW) is fed to the data inputs, which can be alternatively switched through, of each multiplexer and in that the selector inputs (S1 to S8) of the multiplexers (M1 to M8) can be separately activated.

6. Arrangement according to Claim 5, characterized in that the multiplexers (M1 to M8) contain clock-actuated memory stages, which form the memory register (R2).

7. Arrangement according to Claim 5, characterized in that the dataword-multiplexing device (MUX) contains dataword-multiplexers (M111 to M142) each having "a" (3) inputs, of which in each case inputs (EM1) of equal rank are connected to successive outputs of the memory register (R2) and in that all selector inputs (SE) of equal rank of the dataword-multiplexers are connected in parallel.

8. Arrangement according to Claim 4, characterized in that codewords (CW) of 3 or 6 bits in length are used, in that a data word (DW) comprises 4 bits and in that the memory register (R2) comprises 24 memory stages, in that 8 dataword-multiplexers (M111 to M142) are provided for the simultaneous reading out of, in each case, 2 datawords (DW).

9. Arrangement according to Claim 3, characterized in that the first control (ST1) contains an address register (AR), in that the outputs of the address register (AR) are connected to address inputs of read-only memories (ROM1 to ROM3), in that the outputs of the read-only memories (ROM1, to ROM3) are connected via registers (R4, R5, R3, R13) to the selector inputs (S, SE) of the multiplexers (M1 to M8) and of the dataword-multiplexers (M111 to M142) and to the clock inputs (CL) of the memory register (R2), in that a further output of one of the read-only memories (ROM3) is connected to the input of an AND gate (UN) for controlling the write pulses (T_IN) of the memory (ME) and in that the outputs of the address register (AR) are looped back via an addition device (AD), to which the length mode (LM) is also fed, to the address inputs of the address register (AR).

10. Arrangement according to Claim 9, characterized in that the addition device (AD) is contained in a read-only memory (ROM3), which issues, as a new dataword, an address, which is formed corresponding to the address present and the length mode (LM) present.

**Revendications**

1. Dispositif pour convertir des mots de code (CW) de longueur variable en des mots de données (DW) de même longueur, caractérisé par le fait qu'il est prévu un démultiplexeur (DMUX), auquel les mots de code (CW) sont envoyés sous une forme en parallèle, que les sorties du démultiplexeur (DMUX) sont reliées à des entrées parallèles (EP) d'un registre de mémoire (R2), que les sorties parallèles (EP) du registre de mémoire (R2) sont raccordées aux entrées de données (E7) d'une mémoire (ME) par l'intermédiaire d'un dispositif (MUX) de multiplexage des mots de données, et qu'il est prévu des dispositifs de commande (ST1, ST2) pour le démultiplexeur (DMUX), le dispositif (MUX) de multiplexage des mots de données et la mémoire (ME).

2. Dispositif suivant la revendication 1, caractérisé par le fait qu'il est prévu comme mémoire (ME) une mémoire FIRST-IN/FIRST-OUT.

3. Dispositif suivant la revendication 1, caractérisé par le fait que les mots de code (CW) possèdent un multiple entier (1, 2, 3...) du nombre «a» (3) des bits du mot de code le plus court, et que le nombre des étages du registre de mémoire (R2) est égal au nombre «a» des bits du mot de code (CW) le plus court, multiplié par le nombre des bits d'un mot de données (DW) ou d'un multiple entier de ce nombre.

4. Dispositif suivant la revendication 3, caractérisé par le fait que le mot de code (CW) possède deux longueurs différentes, que le mot de code le plus court possède seulement une partie informations (I) ayant une longueur égale à «a» (3) bits, et que le mot de code (CW) le plus long possède également une partie informations (I) et en outre un préambule (P) possédant une longueur égale à «a» bits.

5. Dispositif suivant la revendication 4, caractérisé par le fait qu'il est prévu comme démultiplexeur (DMUX) plusieurs multiplexeurs (M1 à M8), dans lesquels respectivement une entrée de données d'un multiplexeur (M1) est branchée en parallèle avec les entrées correspondantes de données des autres multiplexeurs (M2 à M8), que le préambule (P) éventuellement présent est envoyé aux entrées de données de chaque multiplexeur (M1 à M8) et que la partie informations (I) du mot de code (CW) est envoyée à l'entrée de données de ce multiplexeur, pouvant être interconnectées de façon alternative, et que les entrées de sélection (S1 à S8) des multiplexeurs (M1 à M8) peuvent être commandées séparément.

6. Dispositif suivant la revendication 5, caractérisé par le fait que les multiplexeurs (M1 à M8) comportent des étages de mémoire commandés de façon cadencée, qui forment le registre de mémoire (R2).

7. Dispositif suivant la revendication 8, caractérisé par le fait que le dispositif (MUX) de multiplexage des mots de données contient des multiplexeurs de mots de données (M111 à M142) comportant respectivement «a» (3) entrées, les entrées (EM1) de même rang étant reliées à des sorties successives du registre de mémoire (R2), et que toutes les entrées de sélection de même rang (SE) des multiplexeurs de mots de données sont branchées en parallèle.

8. Dispositif suivant la revendication 4, caractérisé par le fait qu'on utilise des mots de code (CW) possédant une longueur égale à 3 ou 6 bits, qu'un mot de données (DW) comporte 4 bits et que le registre de mémoire (2) comporte 24 étages de mémoire et qu'il est prévu 8 multiplexeurs (M111 à M142) des mots de données pour réaliser la lecture simultanée de respectivement 2 mots de données (DW).

9. Dispositif suivant la revendication 3, caractérisé par le fait que le premier dispositif de commande (ST1) contient un registre d'adresses (AR), que les sorties du registre d'adresses (AR) sont reliées à des entrées d'adresses de mémoires de lecture (ROM1 à ROM3), que les sorties de mémoires de lecture (ROM1 à ROM3) sont reliées par l'intermédiaire de registres (R4, R5, R3, R13) aux entrées de sélection (S, SE) des multiplexeurs (M1 à M8) et des multiplexeurs (M111 à M142) des mots de données et aux entrées de cadence (CL) du registre de mémoire (2), qu'une autre entrée d'une mémoire de lecture (ROM3) est raccordée à l'entrée d'une porte ET (UN) pour la commande de l'impulsion d'enregistrement ($T_{IN}$) de la mémoire (M1), et que les sorties du registre d'adresses (AR) sont couplées par réaction aux entrées d'adresses de ce registre, par l'intermédiaire d'un dispositif additionneur (AD), auquel est également envoyé le mode de longueur (LM).

10. Dispositif suivant la revendication 9, caractérisé par le fait que le dispositif additionneur (AD) est contenu dans une mémoire de lecture (ROM3), qui délivre, comme nouveau mot de données, une adresse qui est formée en fonction de l'adresse appliquée du mode de longueur appliquée (LM).

FIG 1

FIG 2

FIG 3